# EUROPÄISCHE PATENTANMELDUNG

(11) **EP 1 170 752 A1**
(43) Veröffentlichungstag der Anmeldung: **09.01.2002**
(21) Anmeldenummer: 01114332.8
(22) Anmeldetag: 13.06.2001
(51) Int. Cl.: G11C 11/16, G11C 11/15

(54) **Verfahren und Anordnung zur Kompensation von parasitären Stromverlusten**

(30) Priorität: 03.07.2000 DE 10032273
(71) Anmelder: Infineon Technologies AG, 81669 München (DE)
(72) Erfinder: Poechmueller, Peter, 81739 München (DE)
(74) Vertreter: Müller . Hoffmann & Partner Patentanwälte

(57) **Zusammenfassung**

Die Erfindung betrifft ein Verfahren und eine Anordnung zur Kompensation von parasitären Stromverlusten in einem MRAM-Speicherzellenfeld, bei dem bzw. der den einzelnen Wortleitungen (WL) und Bitleitungen (BL) derart bemessene Ströme zuführbar sind, daß an den jeweiligen Kreuzungsstellen der Wortleitungen mit den Bitleitungen die gesamte Stromstärke im wesentlichen konstant ist.

## Beschreibung

Die vorliegende Erfindung betrifft ein Verfahren und eine Anordnung zur Kompensation von parasitären Stromverlusten in einem Speicherzellenfeld aus Wortleitungen, die Wortleitungen kreuzenden Bitleitungen und an den Kreuzungspunkten zwischen den Wortleitungen und den Bitleitungen vorgesehenen Speicherzellen, durch die zu den parasitären Stromverlusten fließende parasitäre Ströme fließen.

Als Beispiel eines Speicherzellenfeldes einer Halbleiterspeicheranordnung ist in Fig. 2 der Aufbau eines MRAM-Speicherzellenfeldes (MRAM = Magnetic Random Access Memory) gezeigt. Dieser MRAM besteht aus Wortleitungen WL1, WL2, WL3, ... und Bitleitungen BL1, BL2, BL3, BL4, ..., welche die Wortleitungen WL1, WL2, WL3, ... im wesentlichen senkrecht kreuzen. An den Kreuzungsstellen zwischen den Wortleitungen WL1, WL2, WL3, ... und den Bitleitungen BL1, BL2, BL3, BL4, ... liegen Speicherzellen, die jeweils durch einen Widerstand R11, R12, ..., R33, R34, allgemein Rij, angedeutet sind.

Dieser Widerstand Rij repräsentiert die Strecke eines Tunnelstromes, der zwischen einer Wortleitung, beispielsweise der Wortleitung WL2, und einer Bitleitung, beispielsweise der Bitleitung BL3, fließt, wenn eine Spannungsdifferenz zwischen dieser Wortleitung WL2 und dieser Bitleitung BL3 vorliegt. Abhängig von einem in die Speicherzelle geschriebenen Magnetfeld nimmt dann dieser Tunnelstrom einen größeren oder kleineren Wert an. Mit anderen Worten, die Speicherzelle kann als ein Binärwiderstand aufgefaßt werden, der mit einem größeren oder kleineren Widerstandswert programmiert ist. Diesen beiden Widerstandswerten kann dann die Informationseinheit "1" oder "0" zugeordnet werden.

Das Programmieren einer Speicherzelle erfolgt also durch Anlegen eines Magnetfeldes. Um nun eine Speicherzelle auf einen Wert "0" oder "1" zu programmieren, muß das Magnetfeld gewisse Schwellenwerte überschreiten. Dabei ist zu beachten, daß diese Speicherzelle eine magnetische Hysterese hat.

Wie in Fig. 2 angedeutet ist, bewirkt beispielsweise ein in der Wortleitung WL2 fließender Gleichstrom I2 ein Magnetfeld M um diese Wortleitung WL2. Die Richtung des Magnetfeldes M ist dabei umgekehrt, wenn der Strom I2 in umgekehrter Richtung fließt. Die Richtung des Magnetfeldes M gibt nun an, ob eine "1" oder ein "0" in eine Speicherzelle eingeschrieben wird.

Es sei nun angenommen, daß der Strom I2 in der Wortleitung WL2 die Informationseinheit "1" bedeutet. Alle Speicherzellen, die mit der Wortleitung WL2 verbunden sind, also die Speicherzellen mit den Widerständen R21, R22, R23 und R24 sind durch den Strom I2 mit dem Magnetfeld M beaufschlagt. Die Hysterese der Speicherzellen mit den Widerständen R21, R22, R23 und R24 bewirkt nun, daß das Magnetfeld M allein noch nicht ausreichend stark ist, um alle diese Speicherzellen aus einem "0"-Zustand in einen "1"-Zustand zu bringen. Vielmehr muß zusätzlich noch eine Bitleitung, beispielsweise die Bitleitung BL3, mit einem Strom I1 angesteuert werden, um an der Schnittstelle der Bitleitung BL3 mit der Wortleitung WL2 ein Magnetfeld zu erzeugen, das durch Überlagerung der durch die Ströme I1 und I2 erzeugten Magnetfelder ausreichend stark ist, um an der Schnittstelle, also im Widerstand R23, den "0"-Zustand in einen "1"-Zustand zu überführen. Mit anderen Worten, durch Ansteuerung von ausgewählten Wortleitungen WLi und ausgewählten Bitleitungen BLj ist es möglich, die Speicherzellen an den Schnittstellen dieser Wort- und Bitleitungen - abhängig von der Richtung des durch die jeweiligen Ströme erzeugten Magnetfeldes - in einen "0"- oder "1"-Zustand zu programmieren.

Bei diesem Programmieren tritt jedoch ein Problem auf, das auf den parasitären Stromverlust durch das aus den Widerständen Rij gebildete Netz zurückzuführen ist. Hat beispielsweise der Strom I2 am Beginn der Wortleitung WL2 eine Größe von 1 mA (in Figur mit "1,0" angedeutet), so fällt dieser Wert nach jedem mit der Wortleitung WL2 verbundenen Widerstand R21, R22, R23, R24 auf einen niedrigeren Wert ab. Zur Vereinfachung der Erläuterung sei angenommen, daß dieser Spannungsabfall an jedem Widerstand 0,1 mA beträgt. Nach dem Widerstand R21 hat der Strom I2 dann also eine Größe von 0,9 mA, nach dem Widerstand R22 eine Größe von 0,8 mA, nach dem Widerstand R23 eine Größe von 0,7 mA und nach dem Widerstand R24 eine Größe von 0,6 mA. Die tatsächlichen Werte sind hiervon verschieden, können aber auf relativ einfache Weise durch eine entsprechende Netzsimulation bestimmt werden. Auch hängen diese tatsächlichen Werte von dem Ersatzwiderstand jeder einzelnen Speicherzelle ab, was aber für das Verständnis der Erfindung nicht wichtig ist.

Ein entsprechender Abfall der Größe der Ströme tritt auch auf den Bitleitungen BL1, BL2, BL3 und BL4 auf und soll wie bei den Wortleitungen zu jeweils 0,1 mA nach jedem Widerstand Rij angenommen werden. So hat in der Bitleitung BL1 der Strom nach dem Widerstand R31 eine Größe von 0,9 mA, nach dem Widerstand R21 eine Größe von 0,8 mA und nach dem Widerstand R11 eine Größe von 0,7 mA. Entsprechendes gilt für die Bitleitungen BL2 bis BL4.

An den Kreuzungsstellen der Wortleitungen WLi mit den Bitleitungen BLj liegen dann Stromstärken vor, die durch Überlagerung der einzelnen Ströme in den jeweiligen Leitungen gegeben sind. So beträgt beispielsweise die gesamte Stromstärke aus dem Strom I2 und dem Strom I1 an der Kreuzungsstelle der Wortleitung WL2 mit der Bitleitung BL3 0,8 mA + 0,8 mA = 1,6 mA. Die entsprechende Stromstärke an der Kreuzung der Wortleitung WL1 mit der Bitleitung BL4 mißt 1,4 mA. Dagegen liegt an der Kreuzungsstelle der Wortleitung WL3 mit der Bitleitung BL1 eine Stromstärke von 1,9 mA vor. Entsprechende Werte können für die übrigen Kreuzungsstellen des Speicherzellenfeldes angegeben werden.

Die gesamte Stromstärke an den jeweiligen Kreuzungsstellen legt aber das lokal zum Programmieren der Speicherzellen zur Verfügung stehende Magnetfeld fest, das stark schwanken kann, wie dies aus dem Beispiel von Fig. 2 mit Stromwerten zwischen 1,9 mA und 1,4 mA folgt. Da die Speicherzellen eine magnetische Hysterese haben und für ihr Programmieren das Überschreiten bestimmter Schwellenwerte erforderlich ist, sind solche Schwankungen des Magnetfeldes äußerst unerwünscht. Mit anderen Worten, die Speicherzellen, die alle im wesentlichen gleich aufgebaut sind und die gleichen Schwellenwerte aufweisen, sollten möglichst mit den gleichen Magnetfeldern programmierbar sein.

Es ist daher Aufgabe der vorliegenden Erfindung, ein Verfahren und eine Anordnung zur Kompensation von parasitären Stromverlusten in einem Speicherzellenfeld zu schaffen, das bzw. die es erlaubt, den einzelnen Speicherzellen jeweils Magnetfelder gleicher Größe zur Verfügung zu stellen.

Diese Aufgabe wird bei einem Verfahren der eingangs genannten Art erfindungsgemäß dadurch gelöst, daß in die einzelnen Wort- und Bitleitungen eingespeiste Ströme derart bemessen sind, daß an den Kreuzungspunkten des Speicherzellenfeldes die Summe der Ströme, die durch die zu jedem einzelnen Kreuzungspunkt gehörenden Wort- und Bitleitungen fließen, im wesentlichen konstant ist.

Bei dem erfindungsgemäßen Verfahren werden also die Wortleitungen und Bitleitungen mit Strömen gespeist, deren Größe unter Berücksichtigung des an jeder Speicherzelle auftretenden Spannungsabfalles so bemessen ist, daß an den Kreuzungspunkten der Wortleitungen und der Bitleitungen die gesamte Stromstärke einen über das Speicherzellenfeld im wesentlichen konstanten Wert hat. Selbstverständlich ist es dabei nicht erforderlich, daß an allen Kreuzungsstellen exakt die gleiche gesamte Stromstärke vorliegt. Vielmehr ist es ausreichend, wenn die Stromstärke an den einzelnen Kreuzungspunkten im wesentlichen die gleiche Größe aufweist. Dies kann auch dadurch erreicht werden, daß jeweils bestimmte Gruppe von Wortleitungen und Bitleitungen mit dem gleichen Strom angesteuert werden, so daß innerhalb der einzelnen Gruppe gewisse, tolerierbare Abweichungen von der idealen gesamten Stromstärke auftreten können. Auf jeden Fall ermöglicht die Erfindung aber eine wesentliche Kompensation des parasitären Stromverlustes in den einzelnen Wortleitungen und Bitleitungen, indem lediglich dafür gesorgt wird, daß die diesen Wortleitungen und Bitleitungen zugeführten Ströme solche Größen aufweisen, daß die parasitären Stromverluste im wesentlichen kompensiert sind.

Eine Anordnung zur Durchführung des erfindungsgemäßen Verfahrens zeichnet sich dadurch aus, daß das Speicherzellenfeld mit Wort- und Bitleitungstreibern versehen ist, die den Wort- und Bitleitungen die unterschiedlich bemessenen Ströme zuzuführen vermögen. Bei dem Speicherzellenfeld handelt es sich in bevorzugter Weise um das Speicherzellenfeld eines MRAMs.

Nachfolgend wird die Erfindung anhand der Zeichnungen näher erläutert. Es zeigen:
- Fig. 1: ein Speicherzellenfeld eines MRAMs zur Veranschaulichung des erfindungsgemäßen Verfahrens und
- Fig. 2: ein in herkömmlicher Weise mit Strömen konstanter Größe beschicktes Speicherzellenfeld eines MRAMs.

Die Fig. 2 ist bereits eingangs erläutert worden. In den Figuren werden einander entsprechende Bauteile mit jeweils den gleichen Bezugszeichen versehen.

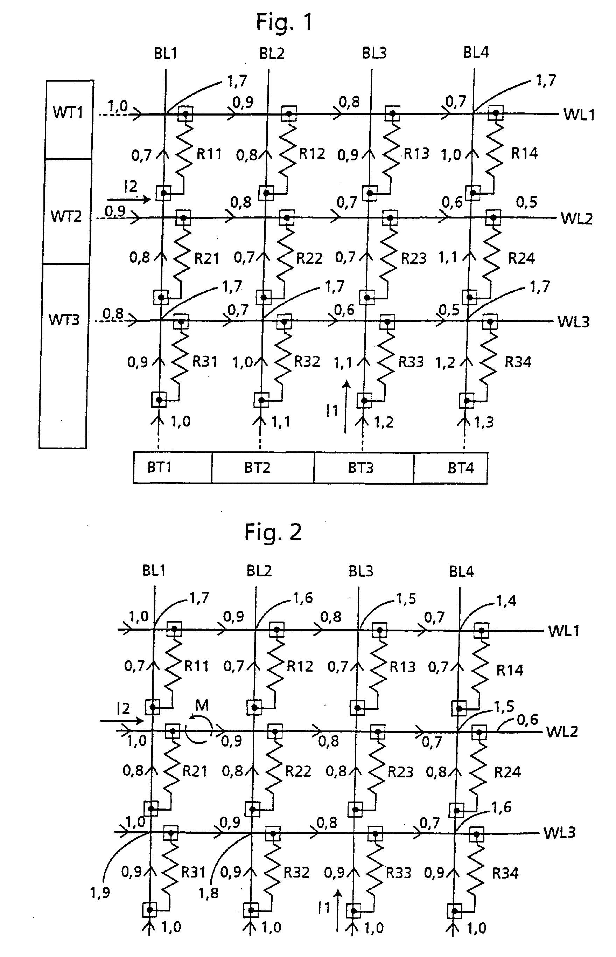

Fig. 1 zeigt ein Speicherzellenfeld eines MRAMs, bei dem Wortleitungstreiber WT1, WT2, WT3 den Wortleitungen WL1, WL2 bzw. WL3 jeweils Ströme mit einer Größe von 1,0 mA, 0,9 mA und 0,8 mA zuführen. In ähnlicher Weise speisen bei diesem MRAM-Speicherzellenfeld Bitleitungstreiber BT1, BT2, BT3 und BT4 den Bitleitungen BL1, BL2, BL3 bzw. BL4 Ströme von 1,0 mA, 1,1 mA, 1,2 mA bzw. 1,3 mA ein.

Wenn nun, wie bei dem Beispiel von Fig. 2 angenommen wird, das an jeder Speicherzelle bzw. an jedem Widerstand Rij ein Spannungsabfall von 0,1 mA auftritt, so hat der Strom I2, der von dem Wortleitungstreiber WT2 abgegeben ist, nach dem Widerstand R21 eine Größe von 0,8 mA, nach dem Widerstand R22 eine Größe von 0,7 mA, nach dem Widerstand R23 eine Größe von 0,6 mA und nach dem Widerstand R24 eine Größe von 0,5 mA. In ähnlicher Weise hat der Strom I1, der von dem Bitleitungstreiber BT3 in die Bitleitung BL3 geliefert ist, nach dem Widerstand R33 eine Größe von 1,1 mA, nach dem Widerstand R23 eine Größe von 1,0 mA und nach dem Widerstand R13 eine Größe von 0,9 mA.

Damit liegen aber an allen Kreuzungsstellen des Speicherzellenfeldes von Fig. 1 gleiche gesamte Stromstärken an den Kreuzungspunkten der einzelnen Wortleitungen WLi mit den Bitleitungen BLj vor: So beträgt die gesamte Stromstärke an dem Kreuzungspunkt der Wortleitung WL2 mit der Bitleitung BL3 0,7 mA + 1,0 mA = 1,7 mA. In ähnlicher Weise beträgt die gesamte Stromstärke an der Kreuzungsstelle der Wortleitung WL3 mit der Bitleitung BL1 0,8 mA + 0,9 mA = 1,7 mA. Gleiches gilt für die Kreuzungsstelle der Wortleitung WL1 mit der Bitleitung BL4, für die 0,7 mA + 1,0 mA = 1,7 mA gilt.

Bei dem erfindungsgemäßen Verfahren bzw. bei der erfindungsgemäßen Anordnung ist also sichergestellt, daß an den einzelnen Kreuzungspunkten zwischen den Wortleitungen und den Bitleitungen die gesamte Stromstärke in den jeweiligen Wortleitungen und Bitleitungen insgesamt einen im wesentlichen konstanten Wert hat. Dies wird erreicht, indem die einzelnen Ansteuerströme, die von den Wortleitungstreibern bzw. Bitleitungstreibern abgegeben sind, in geeigneter Weise bemessen werden.

Wie bereits oben erwähnt wurde, ist es auch möglich, einzelne Gruppen von Wortleitungen bzw. Bitleitungen mit jeweils den gleichen Strömen zu versehen, wobei dann gewisse Abweichungen von einem Idealwert in Kauf genommen werden. Solche Abweichungen sind aber akzeptabel, solange eine gewisse Kompensation parasitärer Stromverluste erreicht wird.

Die Erfindung ist vorzugsweise bei einem MRAM anwendbar. Jedoch kann sie auch bei Speicherzellenfeldern von anderen Speichern in vorteilhafter Weise eingesetzt werden, wenn bei diesen möglichst konstante Ströme für die einzelnen Speicherzellen erwünscht sind.

## Patentansprüche

1. Verfahren zur Kompensation von parasitären Stromverlusten in einem Speicherzellenfeld aus Wortleitungen (WL), die Wort-leitungen (WL) kreuzenden Bitleitungen (BL) und an den Kreuzungspunkten zwischen den Wortleitungen (WL) und den Bitleitungen (BL) vorgesehenen Speicherzellen (R), durch die zu den parasitären Stromverlusten führende parasitäre Ströme fließen,
**dadurch gekennzeichnet, daß** in die einzelnen Wort- und Bitleitungen (WL, BL) eingepeiste Ströme derart bemessen sind, daß an den Kreuzungspunkten des Speicherzellenfeldes die Summe der Ströme (I1, I2), die durch die zu jedem einzelnen Kreuzungspunkt gehörenden Wort- und Bitleitungen fließen, im wesentlichen konstant ist.

2. Verfahren nach Anspruch 1,
**dadurch gekennzeichnet, daß** die in die einzelnen Wort- und Bitleitungen (WL, BL) eingespeisten Ströme unter Berücksichtigung der in den Speicherzellen auftretenden parasitären Ströme bemessen sind.

3. Verfahren nach Anspruch 1 oder 2,
**dadurch gekennzeichnet, daß** Gruppen von Wort- und Bitleitungen (WL, BL) mit jeweils gleich bemessenen Strömen beaufschlagt werden.

4. Anordnung zur Durchführung des Verfahrens nach einem der Ansprüche 1 bis 3,
**dadurch gekennzeichnet, daß** das Speicherzellenfeld mit Wort- und Bitleitungstreibern (WT1 bis WT3, BT1 bis BT4) versehen ist, die den Wort- und Bitleitungen (WL, BL) die unterschiedlich bemessenen Ströme zuzuführen vermögen.

5. Anordnung nach Anspruch 4,
**dadurch gekennzeichnet, daß** das Speicherzellenfeld ein MRAM-Speicherzellenfeld ist.
